# EUROPEAN PATENT SPECIFICATION

(11) **EP 1 581 963 B1**
(45) Date of publication and mention of the grant of the patent: **08.10.2008**
(21) Application number: 04700457.7
(22) Date of filing: 07.01.2004
(51) Int. Cl.: H01J 37/34

(54) **MID SPAN SUPPORT FOR A MAGNETIC ARRAY OF A CYLINDRICAL MAGNETRON SPUTTER DEVICE**
MITTELSPANNENUNTERSTÜTZUNG FÜR EIN MAGNETISCHES ARRAY EINER ZYLINDRISCHEN MAGNETRON-SPUTTER-EINRICHTUNG
SUPPORT A MI-PORTEE POUR RESEAU MAGNETIQUE D'UN DISPOSITIF DE PULVERISATION A MAGNETRON CYLINDRIQUE

(30) Priority: 07.01.2003 US 338190
(43) Date of publication of application: 05.10.2005
(73) Proprietor: VON ARDENNE ANLAGENTECHNIK GMBH, 01324 Dresden (DE)
(72) Inventor: BARRETT, Richard, Lowe, Goffstown, New Hampshire 03045 (US); GREENE, Philip, A., Oakland, CA 94602 (US)
(74) Representative: Adler, Peter
(86) International application number: PCT/EP2004/000045
(87) International publication number: WO 2004/061894

(56) References cited:
- EP-A- 0 537 011
- US-A- 5 108 574
- US-A- 5 213 672
- US-A- 5 364 518

## Description

### BACKGROUND

### Field of the Invention

The present invention generally relates to sputtering systems, and more particularly to positioning of a magnetic array within a cylindrical magnetron.

### Related Art

A cylindrical magnetron utilizes a magnetic array within a target tube. Proper sputtering is dependent upon proper alignment and positioning of the magnetic array within the target tube. Not only must the magnetic array must be properly aligned when installed, in order to ensure proper sputter, the alignment should be maintained until it is necessary to install a new target tube. Prior designs, required a labor intensive, time consuming process that only very skilled technicians could quickly carry out. Furthermore, the magnetic array would frequently become misaligned after only a short time of usage because highly stressed portions of the assembly lead to rapid degradation of the rollers and other various parts.

Several U.S. Patent Applications describe cylindrical magnetrons and the various configurations of magnetic arrays, target tubes, and other components, all of which are hereby incorporated by reference in their entireties: U.S: Patent No. 5,108,574 to Kirs et al; U.S. Patent No. 5,213,672 to Hartig, et al; U.S. Patent No. 5,364,518 to No. Hartig, et al; U.S. Patent No. 5,527,439 to Sieck, et al; U.S. Patent No. 5,725,746 to Dickey et al; and U.S. Patent No. 5,853,816 to Vanderstraeten.

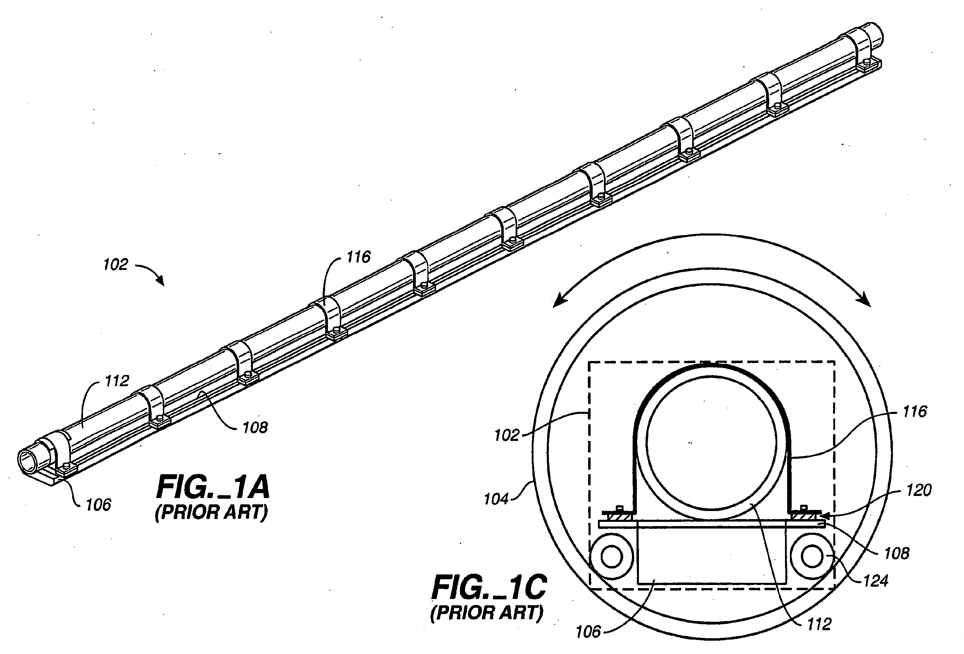

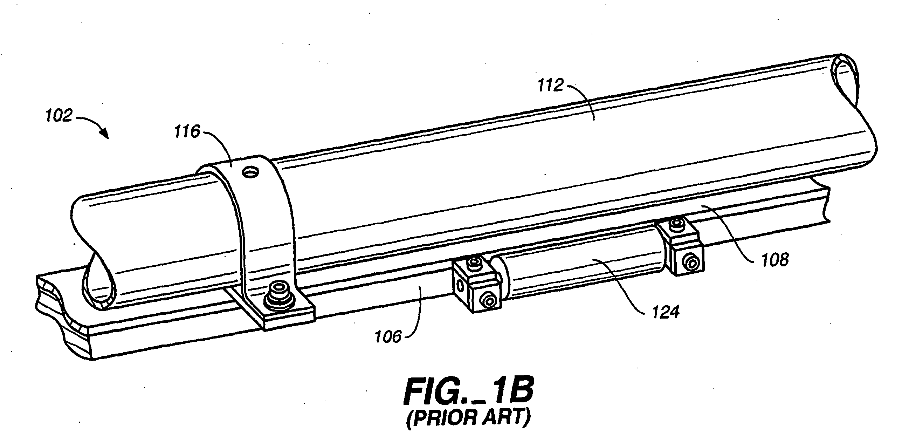

FIGS. 1A - 1C illustrate an example of a prior magnetic assembly 102. Assembly 102 is stationary within a rotating target tube 104 of a cylindrical magnetron. The assembly includes a magnetic array 106 that is mounted to a support pipe 112 that runs the length of the target tube 104. The magnetic array 106 has a backing plate 108 between the support pipe 112 and the array 106. For practical purposes the backing plate 108 will be considered part of magnetic array 106. The support pipe 112 is coupled to the magnetic array 106 via clamps 116 positioned at various points along the pipe and array. The rollers 124 are in tangential contact with the inner diameter of the target tube 104. The rollers are also fixed directly to the magnetic array 106, as seen in FIG. 1B. Thus, the magnetic array 106 is not adjustable in relation to the inner diameter of target tube 104, and has very little freedom of movement. However, fine tuning is possible by deflecting the assembly 102 in along the length of the assembly.

The position of the magnetic array is fine tuned by manipulating shims 120 located between the clamps 116 and the magnetic array 106. Different amounts of shimming may be placed at the different clamps 116. The magnetic array is not free to move, and as a result is not displaced by the full thickness of the shim. This may result in a different amounts of deflection, at times approaching a quasi sinusoidal like pattern. The shimming increases the loading on the rollers and on the end circumference support areas of the support tube. This results in increased compression stresses and premature wear of the rollers and the circumferential end supports. The wear of the rollers, in turn, leads to movement and misalignment of the magnetic array. This misalignment results in less than optimal sputtering with variations in the coatings produced by the magnetrons. Therefore, a more durable and simpler device and method for positioning the magnetic array is needed.

### SUMMARY

A magnetic support assembly is located within the target tube of a cylindrical magnetron, and supports a magnetic array within the target tube. The position of the magnetic array is critical to the sputtering of the target tube material. The support assembly uniformly supports the magnetic array such that the distance between the magnetic array and the target tube is constant along the length of the magnetic array. This results in even and uniform sputtering, and therefore even and uniform coatings on the substrate.

The magnetic support assembly comprises a support member and a support frame. Rollers attached to the support frame are in contact with an inner diameter of the target tube and support the stationary support member as the target tube continually rotates. An support structure is attached to a magnetic array, and the support structure and magnetic array are positioned between the rollers of the support member. The support structure has a length approximately equal to that of the target tube, and the magnetic support assembly is positioned at approximately the middle of the target tube and supports the weight of the magnetic array and support structure from the approximate middle of the target tube.

Another aspect of the invention is a method for positioning a magnetic array having a span within the target tube of a cylindrical magnetron. The method comprises affixing the magnetic array to a supporting member along the span of the magnetic array, attaching a roller structure to the support frame of a supporting member at about the middle of the span, and adjusting a distance between the roller structure and the support member in order to position the magnetic array relative to an inner surface of the target tube. The roller structure, support member, and magnetic array are inserted into the target tube such that the roller structure is at about the middle of the target tube.

### BRIEF DESCRIPTION OF THE FIGURES

FIG. 1A is a perspective view of a prior art magnetic assembly 102.

FIG. 1B is a perspective view of a prior art magnetic assembly 102 seen in FIG. 1A.

FIG. 1C is a cross section of a prior art magnetic assembly 102.

FIG. 2A is a cross section of magnetic support assembly 202.

FIG. 2B is a cross section of magnetic support assembly 250.

FIG. 2C is a cross section of magnetic support assembly 250.

FIG. 2D is a cross section of magnetic support assembly 275.

FIG. 3A is a perspective view of magnetic support assembly 300 partially in a target tube.

FIG. 3B is a perspective view of a support pipe and the fixation with the end block.

FIG. 4 is a perspective view of magnetic support assembly 400.

FIG. 5 is a graph of a deposition profile created by an embodiment of the invention.

Like numbers are used to describe the same components in the various figures.

### DETAILED DESCRIPTION

All of the embodiments of the present invention simplify the installation of a magnetic support assembly within the target tube of a cylindrical magnetron. Additionally, the embodiments result in more uniform coatings, both initially, and after many hours of operation. The embodiments improve the load and stress distribution within the target tube and upon the end blocks of the magnetron, minimize friction between the rotating parts, and provide for true adjustability of the distance between the magnetic array and the target tube. The magnetic array, once installed will remain precisely aligned during the period of time that elapses while the target erodes for the life of the target tube. This results in a magnetron that produces uniform coatings for extended durations without the need for re-adjustment due to wear or other stress induced variations in the component parts. Should any adjustment be necessary, it can be performed at a convenient time, such as when the target tube is changed.

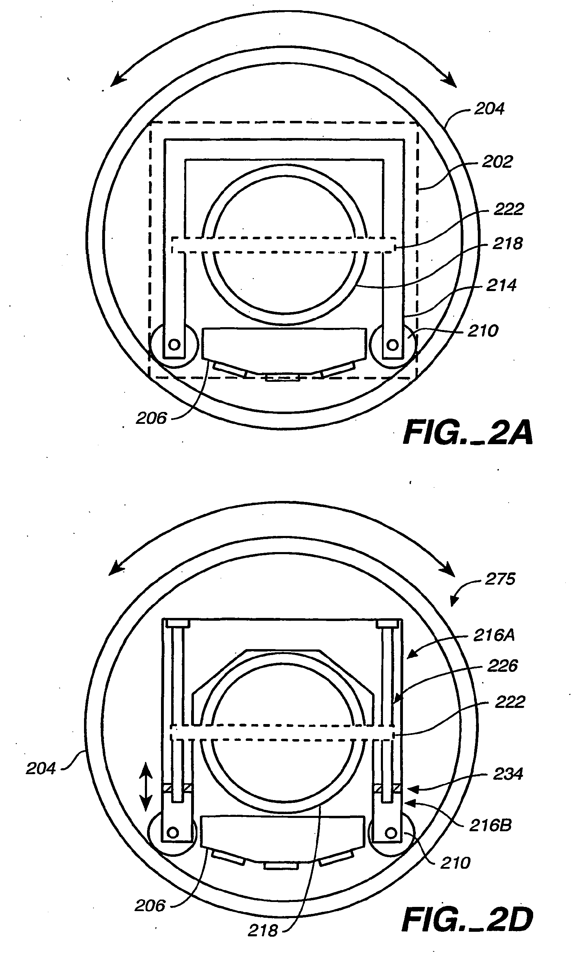

FIG. 2A. is a cross section illustrating magnetic support assembly 202, an embodiment of the present invention, within target tube 204. Magnetic support assembly 202, and all the magnetic support assemblies that will be described, are stationary within the rotating target tube 204.

Magnetic support assembly 202 is a fixed design, i.e. the distance between the magnetic array and target tube 204 is not adjustable at the support assembly. Support pipe 218 is secured to the u-shaped support frame 214 by cross pins 222. Magnetic array 206 is secured to support pipe 218 in any number of ways. It may be secured with screws or bolts that attach directly to support pipe 218, or may alternatively be secured to a backing plate, which is intern secured to support pipe 218. It may also be, for example clamped to the support pipe at various points along the pipe, in a manner similar to that shown in FIG. 1A, or otherwise adhered in any well-known way.

Although support frame 214 is depicted as a simple u-shape, any number of different geometries are within the scope of the present invention. For example, frame 214 may include a hemispherical or stepped inner portion that more closely follows the shape of the cylindrical support pipe 218. Furthermore, the support pipe 218 may be of any geometry. Preferably, support pipe 218 acts a conduit for cooling water provided by one of the magnetron end blocks (not shown). However, support pipe 218 may also be a solid member. The magnetron and the end blocks are described in co-pending application number 10/052732 to Richard Barrett, filed on 1/18/02, and entitled Cylindrical AC/DC Magnetron With Compliant Drive System And Improved Electrical And Thermal Isolation.

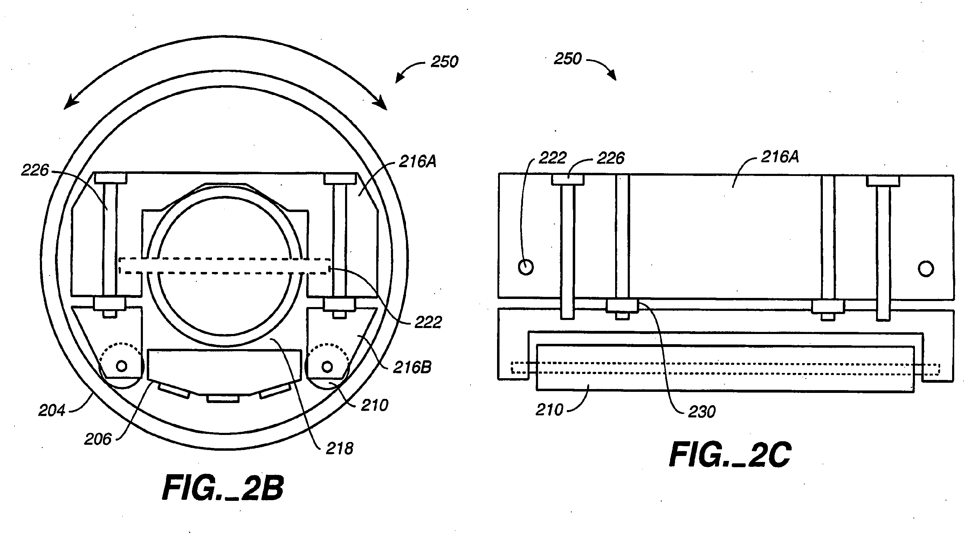

FIGS. 2B and 2C illustrate magnetic support assembly 250, another embodiment of the present invention. Assembly 250 allows adjustment of the distance between the magnetic array 206 and target tube 204. There are two portions of the frame, upper frame 216A, and lower frame 216B. The support pipe 218 is connected to upper frame 216A with connecting pins 222. The support pipe may be connected to the upper frame 216A in any number of ways such as with rivets, screws, adhesive material, clamps, or by welding. Furthermore, the support pipe 218 may be integrally formed with the upper frame 216A, and/or lower frame 216B, in which case the support pipe and (a portion of) the frame would be considered one piece.

The lower flame 216B has the rollers 210 that contact the inner diameter of the rotating target tube 204. The lower frame may be as large or small as desired, and in fact, if the lower frame is minimized it may comprise only rollers and an adjustable coupling to the rollers that adjusts to vary the distance between the rollers (in contact with the inner diameter of the target tube) and the magnetic array 206. Set screws 230 in lower frame 216B are used to adjust the distance between magnetic array 206 and target tube 204 by varying the distance between upper frame 216A and lower frame 216B. The set screws are accessed through passages in upper frame 216A. Clamp screws 226 hold the upper and lower frame together. The set screws 230 are shown threaded into lower frame 216B, however the set screws may be configured many different ways, such as for example being threaded in the upper frame 216A and abutting a solid portion of lower frame 216B or vice versa.

FIG. 2D illustrates magnetic support assembly 275, another embodiment of the present invention. Magnetic support assembly 275 is similar to magnetic support assembly 250, but shims 234 are used to vary the distance between the magnetic array 206 and the target tube 204. The shims 234 are positioned between upper frame 216A and lower frame 216B in order to vary the distance between the upper and lower frame and thus between the magnetic array 206 and the inner diameter of target tube 204.

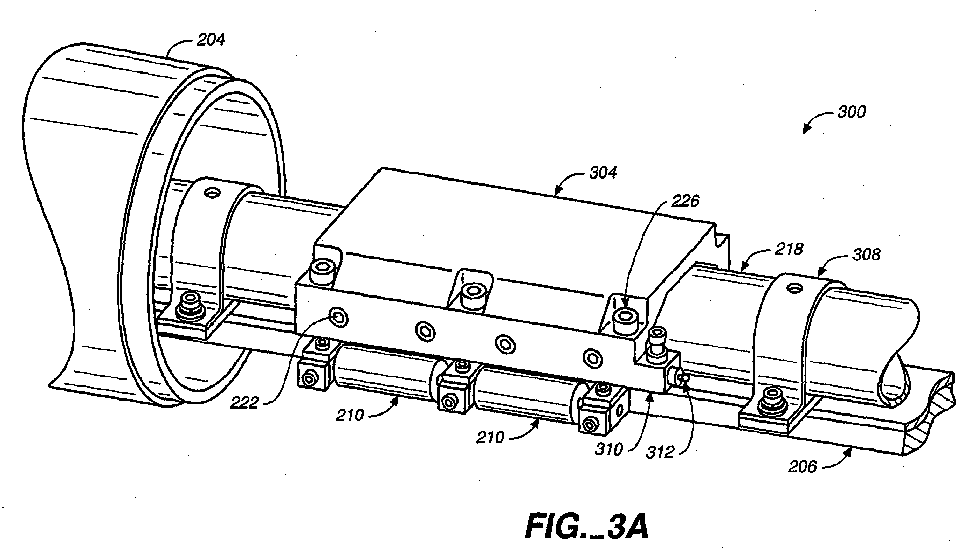

FIG. 3A illustrates magnetic support assembly 300 according to another embodiment of the invention. Assembly 300 has a fixed frame 304 with two rollers 210 per side. The previously described assemblies had one roller per side. It is envisioned that any number of rollers can be included in an assembly, although preferably two are included to minimize cost. The rollers are made of a very durable material such as nylon that does not break down in water, or in very high electrical and magnetic fields, and the very high temperatures common in high power cylindrical magnetrons. Preferably the nylon has other constituents such as finely divided particles of molybdenum disulphide (MoS²) to enhance its load bearing capabilities while maintaining the impact resistance inherent to nylon. Additionally, it is preferred that the nylon (composite) is cast, although it may also be extruded or otherwise formed, and includes oil or other lubricant for improved frictional characteristics. Furthermore, the rollers 210 are continually lubricated from lubricant reservoir 310. The reservoir is filled with lubricant through nipple 312 prior to installation of the magnetic support assembly 300 into target tube 204. Although the reservoir can easily be periodically refilled, it is sufficiently large to provide continual lubrication throughout the life of a target tube. Clamp 308 holds the magnetic array 206 to the support pipe 318, one of the many ways discussed earlier of adhering support pipe 318 to magnetic array 206.

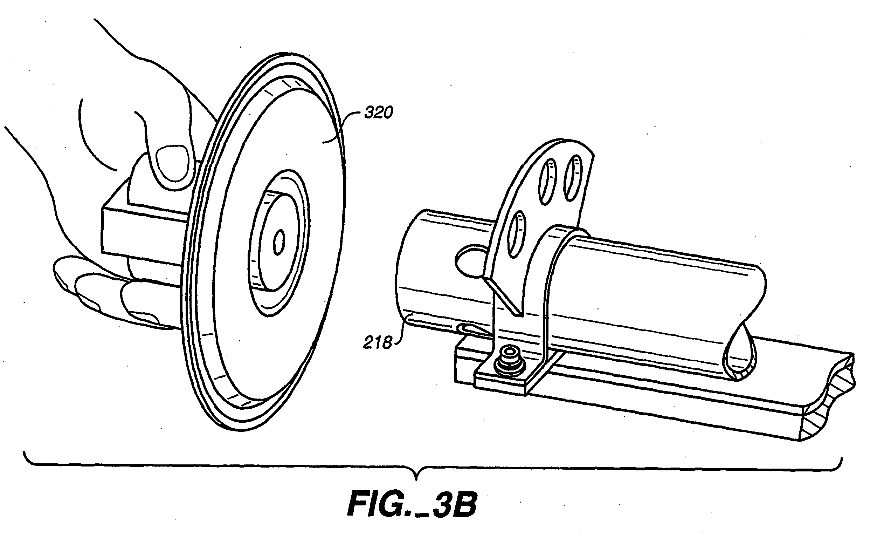

In all of the embodiments discussed thus far, the magnetic array 206 and support pipe 218 are supported in three positions. At each end of the target tube 204 there is an end plate 320, as can be seen in FIG. 3B. Each end plate 320 has a circular groove in which support pipe 218 fits. The end plate and the groove support the pipe 218 at each end of the pipe. The support pipe is approximately the length of the target tube, but may be slightly longer or shorter than the target tube, depending on the particular configuration of the end block utilized. The magnetic support assemblies depicted in all of the various figures are positioned at roughly the middle of the length of the support pies 218 so that when they are inserted into a target tube 204, they will support and position the magnetic array 206 at roughly the middle of the target tube. While it is preferred to use one support assembly in the middle of the pipe and target tube, more than one support assembly can be utilized to support the pipe and magnetic array at various locations along the pipe. While this is more costly, in coating situations requiring long target tubes where sagging of the support pipe is more likely, or in situations where very high precision is of the utmost importance, utilizing more than one support assembly may be advantageous.

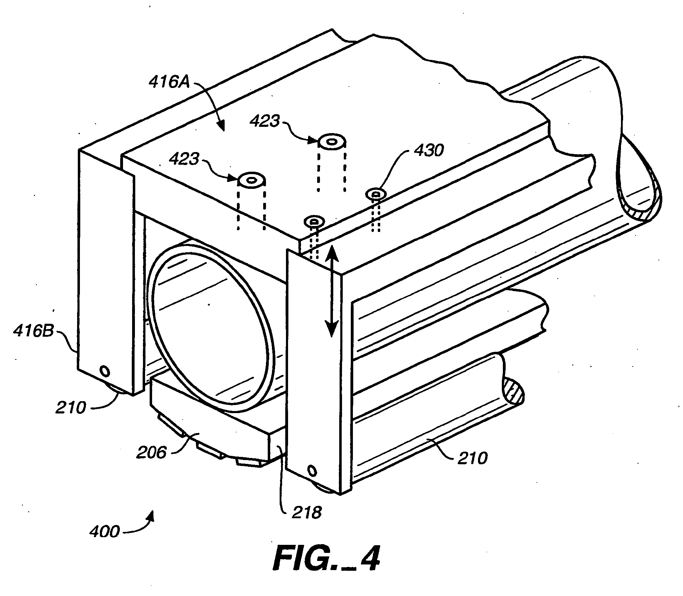

FIG. 4 is a perspective view of magnetic support assembly 400. Magnetic support assembly 400 comprises an upper frame 416A and a lower frame 416B. The support pipe and magnetic array 206 are connected to upper frame 416A with support pins 423. Upper frame 416A can be separated from lower frame 416b by jack screws 430. This intern varies the distance between the magnetic array 206 and the inner diameter of the target tube (not shown). Support pins 423 may also be used to vary the distance between the magnetic array and the target tube.

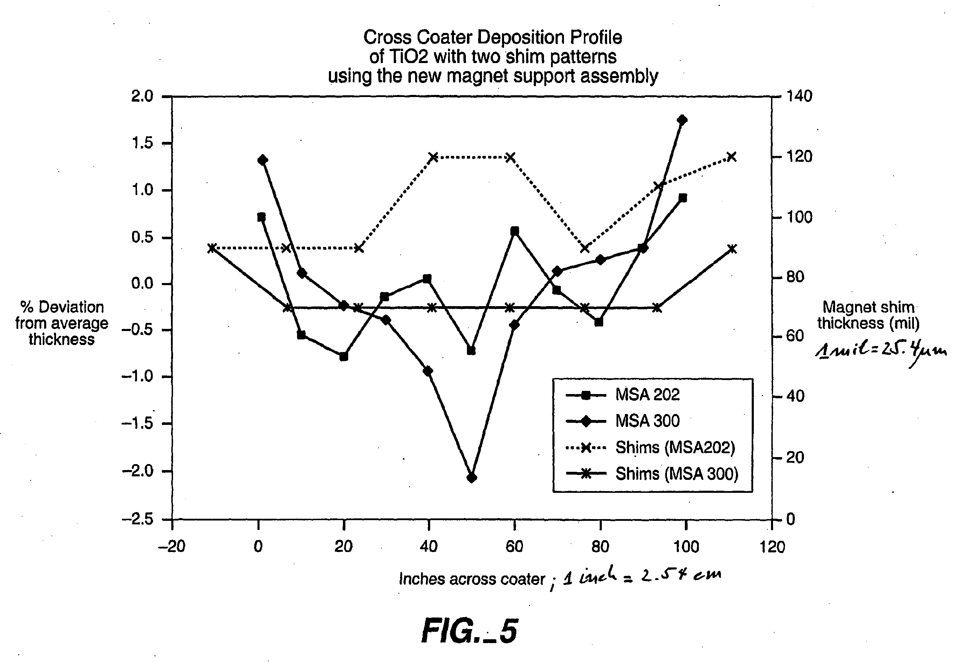

FIG. 5 is a graph of a TiO₂ coating deposited with a cylindrical magnetron utilizing an embodiment of the present invention, and with a cylindrical magnetron using a prior art magnetic support assembly (shortly after installation and alignment) as seen in FIGS. 1. The coating deposited with present invention is much more uniform across the entire length of the coater. The uniformity profiles shown are after the prior support assemblies were freshly tuned, under optimum conditions. As described previously, the prior assembly was prone to quickly lose alignment and thus would typically result in a coating inferior to the one shown in the graph, whereas the present invention solves that problem, and produces uniform coatings for the life of the target tube. Therefore, a coater utilizing any of the embodiments of the present invention will produce a coating far superior to that produced with prior designs.

While particular embodiments of the present invention and their advantages have been shown and described, it should be understood that various changes, substitutions, and alterations can be made therein.

## Claims

1. A method for positioning a magnetic array (206) having a span within the target tube (204) of a cylindrical magnetron, the method comprising:
affixing the magnetic array (206) to a supporting member (218) along the span of the magnetic array (206);
providing a roller structure (210) at the middle of the span;
adjusting a distance between the roller structure (210) and the support member (218) in order to position the magnetic array (206) relative to an inner surface of the target tube (204); and
inserting the roller structure (210), support member (218), and magnetic array (206) into the target tube (204) such that the roller structure (210) is at the middle of the length of the target tube (204)
**characterized by**
supporting the supporting member (218) and thereby the magnetic array (206) at the middle of the length of the magnetic support member (218) with a support frame (214) that contacts the inner circumference of the target tube (204) with rollers (210) and is adapted to adjust the distance of the magnet array (206) from the inner circumference of the target tube (204).

2. The method of claim **1, characterized in that** adjusting the distance comprises turning a set screw (230).

3. The method of claim 1, **characterized in that** adjusting the distance comprises inserting one or more pieces (234) of material between the roller structure (210) and the support frame (214, 216).

4. The method of claim 3, **characterized by** supporting the support member (218) at three positions, at least one of the positions at the mid-span of the support member (218).

5. The method of claim 4, **characterized by** adjusting the distance of the magnet array (206) from the inner circumference measured at the mid-span of the support member (218).

6. The method of claim 5, **characterized in that** adjusting the distance comprises varying the distance between an upper (216A) and a lower portion (216B) of the support frame (214), one of the portions operable to move freely relative to the other portion.

7. The method of claim 6, **characterized in that** adjusting the distance comprises adjusting one or more screws including at least one set-screw (230).

8. The method of claim 6, **characterized in that** t adjusting the distance comprises inserting shims (234) between the upper (216A) and lower portions (216B) of the support frame (214).

9. The method of claim 4, **characterized in that** supporting comprises bearing a load of the magnetic array (206) and support member (218) and distributing the load, the load at the middle of the span supported by the target tube (204) through one or more rotating elements (210).

10. A magnetic support assembly (250; 275) for an arrangement in a cylindrical magnetron, having a target tube (204) and an elongated support structure (218) attached to a magnetic array (206) and having a length equal to that of the target tube (204), the magnetic support assembly (250; 275) positioned with its middle at the middle of the length of the target tube (204) and supporting the weight of the magnetic array (206) and support structure (218) from the middle of the target tube (204)., and rollers (210) in contact with an inner diameter of the target tube (204), **characterized by** an U-shaped support frame (214); the rollers (210) attached to the U-shaped support frame (214) and the support structure (218) and magnetic array (206) positioned between the rollers (210) of the U-shaped support frame (214).

11. The magnetic support assembly of claim 10, **characterized by** an adjustment mechanism (216A; 216B; 230; 234; 423) that is adapted to define the distance of the magnetic array (206) in relation to an inner surface of the target tube (204).

12. The support assembly of claim 10, **characterized by** a lubrication reservoir that is adapted to provide continual lubrication to the rollers (210) during operation of the magnetron.

13. The support assembly of claim 10, **characterized in that** the rollers (210) comprise nylon.

14. The support assembly of claim 13, **characterized in that** the rollers (210) further comprise molybdenum disulphide and a lubricant.

15. The magnetic support assembly of claim 11, **characterized in that** the support structure adjustment mechanism (216A; 216B; 230; 423) comprises one or more set screws (230; 423) that are adapted to adjust the position of the support member (218) and magnet array (206) relative to an inner surface of the target tube (204).

16. The magnetic support assembly of claim 11, **characterized in that** the support structure adjustment mechanism (216A; 216B; 230; 234; 423) comprises shims (234) that are adapted to adjust the position of the support member (218) and magnet array (206) relative to an inner surface of the target tube (204).

17. The magnetic support assembly of claim 11, **characterized in that** the magnet array (206) is affixed to the support member (218), and wherein the support member (218) is moveable relative to the support frame (214).

## Patentansprüche

1. Verfahren zur Positionierung einer Magnetanordnung (206) mit einer bestimmten Spannlänge in einer Targetröhre (204) eines zylindrischen Magnetrons, wobei das Verfahren umfasst:
Befestigen der Magnetanordnung (206) an einem Halterungselement (218) entlang der Spannlänge der Magnetanordnung (206);
Bereitstellen einer Rollenstruktur (210) in der Mitte der Spannlänge;
Einstellen eines Abstands zwischen der Rollenstruktur (210) und dem Halterungselement (218), um die Magnetanordnung (206) in Bezug auf eine Innenseite der Targetröhre (204) zu positionieren; und
Einfügen der Rollenstruktur (210), des Halterungselements (218) und der Magnetanordnung (206) in die Targetröhre (204) in solcher Weise, dass sich die Rollenstruktur (210) in der Mitte der Länge der Targetröhre (204) befindet;
**gekennzeichnet durch**
Abstützen des Halterungselements (218) und **dadurch** der Magnetanordnung (206) in der Mitte der Länge des Magnethalterungselements (218) mit einem Stützrahmen (214), der mit den Rollen (210) in Kontakt zu der Innenumfangsfläche der Targetröhre (204) steht und dafür ausgelegt ist, den Abstand der Magnetanordnung (206) zu der Innenumfangsfläche der Targetröhre (204) anzupassen.

2. Verfahren nach Anspruch 1, **dadurch gekennzeichnet, dass** das Anpassen des Abstands das Drehen einer Stellschraube (230) umfasst.

3. Verfahren nach Anspruch 1, **dadurch gekennzeichnet, dass** das Anpassen des Abstands das Einfügen eines oder mehrerer Materialstücken (234) zwischen der Rollenstruktur (210) und dem Stützrahmen (214, 216) umfasst.

4. Verfahren nach Anspruch 3, **gekennzeichnet durch** Stützen des Halterungselements (218) an drei Positionen, wobei zumindest eine der Positionen in der Mitte der Spannlänge des Halterungselements (218) liegt.

5. Verfahren nach Anspruch 4, **gekennzeichnet durch** Einstellen des Abstands der Magnetanordnung (206) zu der Innenumfangsfläche, gemessen in der Mitte der Spannlänge des Halterungselements (218).

6. Verfahren nach Anspruch 5, **dadurch gekennzeichnet, dass** das Einstellen des Abstands das Ändern des Abstands zwischen einem oberen (216A) und einem unteren (216B) Abschnitt des Stützrahmens (214) umfasst, wobei einer der Abschnitte derart ausgelegt ist, dass er sich in Bezug auf den anderen Abschnitt frei verschieben lässt.

7. Verfahren nach Anspruch 6, **dadurch gekennzeichnet, dass** das Einstellen des Abstands das Einstellen einer oder mehrerer Schrauben, darunter zumindest einer Stellschraube (230) umfasst.

8. Verfahren nach Anspruch 6, **dadurch gekennzeichnet, dass** das Einstellen des Abstands das Einfügen von Abstandsstücken (234) zwischen dem oberen (216A) und dem unteren (216B) Abschnitt des Stützrahmens (214) umfasst.

9. Verfahren nach Anspruch 4, **dadurch gekennzeichnet, dass** das Abstützen das Aufnehmen einer Last der Magnetanordnung (206) und des Halterungselements (218) und das Verteilen der Last umfasst, wobei die Last in der Mitte der Spannlänge über ein oder mehrere rotierende Elemente (210) durch die Targetröhre (204) aufgenommen wird.

10. Magnethalterungsanordnung (250, 275) für eine Anordnung in einem zylindrischen Magnetron mit einer Targetröhre (204) und einer länglichen Halterungsstruktur (218), die an einer Magnetanordnung (206) befestigt ist und die eine Länge aufweist, die gleich der Länge der Targetröhre (204) ist, wobei die Magnethalterungsanordnung (250; 275) mit ihrer Mitte in der Mitte der Länge der Targetröhre (204) positioniert ist und das Gewicht der Magnetanordnung (206) sowie der Halterungsstruktur (218) von der Mitte der Targetröhre (204) aufnimmt, und wobei Rollen (210) in Kontakt mit einer inneren Umfangsfläche der Targetröhre (204) stehen, **gekennzeichnet durch** einen U-förmigen Stützrahmen (214), wobei die Rollen (210) an dem U-förmigen Stützrahmen (214) angebracht sind und die Halterungsstruktur (218) sowie die Magnetanordnung (206) zwischen den Rollen (210) und dem U-förmigen Stützrahmen (214) angeordnet sind.

11. Magnethalterungsanordnung nach Anspruch 10, **gekennzeichnet durch** einen Einstellmechanismus (216A, 216B; 230; 234; 423), der dafür ausgelegt ist, den Abstand der Magnetanordnung (206) in Bezug auf eine Innenfläche der Targetröhre (204) zu definieren.

12. Halterungsanordnung nach Anspruch 10, **gekennzeichnet durch** einen Schmiermittelvorratsbehälter, der dafür ausgelegt ist, eine kontinuierliche Schmierung für die Rollen (210) während des Betriebs des Magnetrons zu liefern.

13. Halterungsanordnung nach Anspruch 10, **dadurch gekennzeichnet, dass** die Rollen (210) Nylon umfassen.

14. Halterungsanordnung nach Anspruch 13, **dadurch gekennzeichnet, dass** die Rollen (210) ferner Molybdändisulfid und ein Schmiermittel umfassen.

15. Magnethalterungsanordnung nach Anspruch 11, **dadurch gekennzeichnet, dass** der Einstellmechanismus (216A, 216B; 230; 423) für die Halterungsstruktur eine oder mehrere Stellschrauben (230; 423) umfasst, die dafür ausgelegt sind, die Position des Halterungselements (218) und der Magnetanordnung (206) in Bezug auf die Innenfläche der Targetröhre (204) einzustellen.

16. Magnethalterungsanordnung nach Anspruch 11, **dadurch gekennzeichnet, dass** der Einstellmechanismus (216A, 216B; 230; 234; 423) für die Halterungsstruktur Abstandsstücken (234) umfasst, die dafür ausgelegt sind, die Position des Halterungselements (218) und der Magnetanordnung (206) in Bezug auf eine Innenfläche der Targetröhre (204) einzustellen.

17. Magnethalterungsanordnung nach Anspruch 11, **dadurch gekennzeichnet, dass** die Magnetanordnung (206) an dem Halterungselement (218) befestigt ist und dass das Halterungselement (218) in Bezug auf den Stützrahmen (214) bewegbar ist.

## Revendications

1. Procédé de positionnement d'un réseau magnétique (206) ayant une portée dans le tube cible (204) d'un magnétron cylindrique, le procédé comprenant :
la fixation du réseau magnétique (206) à un élément de support (218) le long de la portée du réseau magnétique (206) ;
la fourniture d'une structure à rouleaux (210) au centre de la portée ;
le réglage d'une distance entre la structure à rouleaux (210) et l'élément de support (218) afin de positionner le réseau magnétique (206) par rapport à une surface interne du tube cible (204) ; et
l'insertion de la structure à rouleaux (210),
l'élément de support (218) et le réseau magnétique (206) dans le tube cible (204) de telle sorte que la structure à rouleaux (210) soit au milieu de la longueur du tube cible (204)
**caractérisé par**
le support de l'élément de support (218) et donc du réseau magnétique (206) au milieu de la longueur de l'élément de support magnétique (218) avec un cadre de support (214) qui entre en contact avec la circonférence interne du tube cible (204) au moyen de rouleaux (210) et qui est adapté pour régler la distance du réseau magnétique (206) depuis la circonférence interne du tube cible (204).

2. Procédé selon la revendication 1, **caractérisé en ce que** le réglage de la distance comprend la rotation d'une vis de pression (230).

3. Procédé selon la revendication 1, **caractérisé en ce que** le réglage de la distance comprend l'insertion d'une ou de plusieurs pièces (234) de matériau entre la structure à rouleaux (210) et le cadre de support (214, 216).

4. Procédé selon la revendication 3, **caractérisé par** le support de l'élément de support (218) en trois positions, au moins une des positions étant à mi-portée de l'élément de support (218).

5. Procédé selon la revendication 4, **caractérisé par** le réglage de la distance du réseau magnétique (206) depuis la circonférence interne mesurée à mi-portée de l'élément de support (218).

6. Procédé selon la revendication 5, **caractérisé en ce que** le réglage de la distance comprend la variation de la distance entre une partie supérieure (216A) et une partie inférieure (216B) du cadre de support (214), une des parties pouvant être actionnée pour se déplacer librement par rapport à l'autre partie.

7. Procédé selon la revendication 6, **caractérisé en ce que** le réglage de la distance comprend le réglage d'une ou de plusieurs vis comprenant au moins une vis de pression (230).

8. Procédé selon la revendication 6, **caractérisé en ce que** le réglage de la distance comprend l'insertion de cales (234) entre les parties supérieure (216A) et inférieure (216B) du cadre de support (214).

9. Procédé selon la revendication 4, **caractérisé en ce que** le support comprend le support d'une charge du réseau magnétique (206) et de l'élément de support (218) et la distribution de la charge, la charge au centre de la portée étant supportée par le tube cible (204) à travers un ou plusieurs éléments rotatifs (210).

10. Dispositif de support magnétique (250 ; 275) conçu pour être agencé dans un magnétron cylindrique, ayant un tube cible (204) et une structure de support allongée (218) fixée à un réseau magnétique (206) et ayant une longueur égale à celle du tube cible (204), le dispositif de support magnétique (250 ; 275) étant positionné avec son centre au milieu de la longueur du tube cible (204) et supportant le poids du réseau magnétique (206) et de la structure de support (218) depuis le centre du tube cible (204), et des rouleaux (210) en contact avec un diamètre interne du tube cible (204), **caractérisé par** un cadre de support en forme de U (214) ; les rouleaux (210) étant fixés au cadre de support en forme de U (214) et la structure de support (218) ainsi que le réseau magnétique (206) étant positionnés entre les rouleaux (210) du cadre de support en forme de U (214).

11. Dispositif de support magnétique selon la revendication 10, **caractérisé par** un mécanisme de réglage (216A ; 216B ; 230 ; 234 ; 423) qui est adapté pour définir la distance du réseau magnétique (206) par rapport à une surface interne du tube cible (204).

12. Dispositif de support selon la revendication 10, **caractérisé par** un réservoir de lubrification qui est adapté pour fournir une lubrification continue aux rouleaux (210) pendant le fonctionnement du magnétron.

13. Dispositif de support selon la revendication 10, **caractérisé en ce que** les rouleaux (210) comprennent du nylon.

14. Dispositif de support selon la revendication 13, **caractérisé en ce que** les rouleaux (210) comprennent en outre du bisulfure de molybdène et un lubrifiant.

15. Dispositif de support magnétique selon la revendication 11, **caractérisé en ce que** le mécanisme de réglage de la structure de support (216A ; 216B ; 230 ; 423) comprend une ou plusieurs vis de pression (230 ; 423) qui sont adaptées pour régler la position de l'élément de support (218) et du réseau magnétique (206) par rapport à une surface interne du tube cible (204).

16. Dispositif de support magnétique selon la revendication 11, **caractérisé en ce que** le mécanisme de réglage de la structure de support (216A ; 216B ; 230 ; 234 ; 423) comprend des cales (234) qui sont adaptées pour régler la position de l'élément de support (218) et du réseau magnétique (206) par rapport à une surface interne du tube cible (204).

17. Dispositif de support magnétique selon la revendication 11, **caractérisé en ce que** le réseau magnétique (206) est fixé à l'élément de support (218), et dans lequel l'élément de support (218) est mobile par rapport à la structure cadre de support (214).
